(19) Europäisches Patentamt
European Patent Office
Office européen des brevets

(11) EP 4 806 952 A1

(12) **EUROPEAN PATENT APPLICATION**
published in accordance with Art. 153(4) EPC

(43) Date of publication:
**16.09.2026 Bulletin 2026/38**

(21) Application number: **24888502.2**

(22) Date of filing: **21.10.2024**

(51) International Patent Classification (IPC):
***C08L 67/00*** (2006.01) ***C08K 3/04*** (2006.01)
***C08L 33/08*** (2006.01) ***C08L 63/00*** (2006.01)
***C08L 63/08*** (2006.01) ***H05K 9/00*** (2006.01)

(52) Cooperative Patent Classification (CPC):
**C08K 3/04; C08L 33/08; C08L 63/00; C08L 63/08; C08L 67/00; H05K 9/00**

(86) International application number:
**PCT/JP2024/037353**

(87) International publication number:
**WO 2025/100204 (15.05.2025 Gazette 2025/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **07.11.2023 JP 2023189712**

(71) Applicant: **Toray Industries, Inc.**
**Tokyo 103-8666 (JP)**

(72) Inventors:
- **MORIOKA, Nobuhiro**
**Nagoya-shi, Aichi 455-8502 (JP)**
- **SUGISAWA, Koshiro**
**Nagoya-shi, Aichi 455-8502 (JP)**

(74) Representative: **Mewburn Ellis LLP**
**Aurora Building**
**Counterslip**
**Bristol BS1 6BX (GB)**

# (54) POLYESTER RESIN COMPOSITION AND MOLDED ARTICLE THEREOF

(57) A thermoplastic polyester resin composition including: 100 parts by weight of a thermoplastic polyester resin (A); and 0.1 to 5 parts by weight of a carbon nanotube (B) having a high-temperature-side combustion peak of 650°C to 900°C in thermogravimetric analysis upon heating in air at 10°C/min. A polyester resin composition that can provide a molded article having high electromagnetic wave absorbing properties, excellent mechanical strength, and excellent laser marking property is obtained.

EP 4 806 952 A1

## Description

### TECHNICAL FIELD

The present invention relates to a thermoplastic polyester resin composition excellent in electromagnetic wave absorbing properties, mechanical strength, and laser marking property, and a molded article thereof.

### BACKGROUND ART

Thermoplastic polyester resins, particularly polybutylene terephthalate-based resins, are excellent in injection moldability, light weight, molding processability, mechanical properties, and heat resistance and thus widely used for housings and structural members of office automation equipment, communication equipment, electrical and electronic equipment, and automotive electrical equipment, and the demand thereof is increasing year by year.

On the other hand, with the spread of 5G communication and automatic driving technology for realizing a safer and more comfortable society, it is expected that the use range of high-frequency electromagnetic waves will be further expanded in the future in communication equipment such as a wireless communication system and automotive electrical equipment such as a millimeter wave radar used for the 5G communication and the automatic driving technology.

However, as the frequency increases, noise is more likely to be emitted during conversion into electromagnetic waves, and there is also a problem that communication equipment or automotive electrical equipment malfunctions due to deterioration of an internal noise environment. For example, in a millimeter wave radar, a radio wave reflected by a structure such as a guardrail is mixed with a radio wave reflected from a target to be detected by the radar, so that a false image that does not actually exist may appear on a radar screen.

In order to prevent such malfunctions, housings and structural members used for communication equipment and automotive electrical equipment are required to have excellent electromagnetic wave absorbing properties while maintaining excellent injection moldability, light weight, molding processability, mechanical properties, and heat resistance.

To solve the above problem, Patent Document 1 discloses a thermoplastic resin composition containing a thermoplastic resin and a carbon nanotube. Further,

Patent Document 2 discloses a resin composition comprising a thermoplastic resin, carbon black, a carbon fiber, and a glycerin fatty acid ester.

### PRIOR ART DOCUMENTS

[Patent Documents]

[Patent Document 1] WO 2021/256488
[Patent Document 2] JP 2023-28689 A

### SUMMARY OF THE INVENTION

### PROBLEMS TO BE SOLVED BY THE INVENTION

On the other hand, information such as lot numbers and serial numbers is marked on product surfaces of mechanical parts, electrical/communication parts, automobile parts, and the like. Examples of conventionally and generally adopted marking methods include a method of forming irregularities on a product surface, a method of directly printing on a product surface using an ink, a method of attaching a printed matter to a product surface, and a method of laser-marking a product surface.

Among these, the laser marking method has been increasingly adopted in recent years since no solvent is used and the tact time is short in this method, and hence a laser marking property has come to be required for resin compositions used for resin molded articles. For laser marking on a resin molded article, a coloring method in which a surface of the resin molded article is scorched or discolored using laser light is often used.

However, in the technique of Patent Document 1, the content of carbon nanotubes needs to be increased in order to improve electromagnetic wave absorbing properties, so that the balance between the electromagnetic wave absorbing properties and the laser marking property was not sufficient. In the technique of

Patent Document 2, a considerable amount of carbon black is included, and hence there was a problem that the strength of the resin composition was reduced.

Therefore, an object of the present invention is to provide a resin composition having good electromagnetic wave absorbing properties, excellent mechanical strength, and excellent laser marking property for molded articles, and a molded article thereof.

MEANS FOR SOLVING THE PROBLEMS

To solve the above-described problems, the present invention includes the following configurations.

(1) A thermoplastic polyester resin composition comprising: 100 parts by weight of a thermoplastic polyester resin (A); and 0.1 to 5 parts by weight of a carbon nanotube (B) having a high-temperature-side combustion peak of 650°C to 900°C in thermogravimetric analysis upon heating in air at 10°C/min.
(2) The thermoplastic polyester resin composition according to (1), wherein, when a 3 mm-thick square plate formed by molding the thermoplastic polyester resin composition is subjected to measurement by a free space method in a band of 60 to 90 GHz, the composition shows a reflection loss S11 of -3 dB or less and a transmission loss S21 of -20 dB or less.
(3) The thermoplastic polyester resin composition according to (1) or (2), having a volume resistivity of $1.0 \times 10^5$ to $1.0 \times 10^{15}$ $\Omega\cdot$m.
(4) The thermoplastic polyester resin composition according to any one of (1) to (3), further comprising 1 to 100 parts by weight of a vinyl copolymer (D) with respect to 100 parts by weight of the thermoplastic polyester resin (A).
(5) The thermoplastic polyester resin composition according to any one of (1) to (4), further comprising 1 to 20 parts by weight of an ethylene/alkyl acrylate copolymer (E) with respect to 100 parts by weight of the thermoplastic polyester resin (A).
(6) The thermoplastic polyester resin composition according to any one of (1) to (5), further comprising 0.1 to 10 parts by weight of a compound (F) having in each molecule two or more functional groups capable of reacting with a carboxyl group with respect to 100 parts by weight of the thermoplastic polyester resin (A).
(7) The thermoplastic polyester resin composition according to (6), wherein the compound (F) having in each molecule two or more functional groups capable of reacting with a carboxyl group is an epoxy compound.
(8) The thermoplastic polyester resin composition according to any one of (1) to (7), having electromagnetic wave absorbing properties.
(9) A molded article obtained by molding the thermoplastic polyester resin composition according to any one of (1) to (8).

EFFECT OF THE INVENTION

The present invention can provide a resin composition that can provide a molded article that has high electromagnetic wave absorbing properties, excellent mechanical strength, and excellent laser marking property. Therefore, the thermoplastic polyester resin composition of the present invention is useful for various applications of electromagnetic wave-absorbing molded articles

MODE FOR CARRYING OUT THE INVENTION

Hereinafter, the present invention will be described in detail.

The thermoplastic polyester resin (A) used in the present invention (which may be hereinafter referred to as "component (A)") is a polymer or copolymer having, as a main structural unit, at least one residue selected from the group consisting of (1) a residue of a dicarboxylic acid or an ester-forming derivative thereof and a diol or an ester-forming derivative thereof, (2) a residue of a hydroxycarboxylic acid or an ester-forming derivative thereof, and (3) a residue of a lactone. Here, the expression "as a main structural unit" refers to having 50 mol% or more of at least one residue selected from the group consisting of (1) to (3) in all the structural units. In a preferred mode, such residues are contained at 80 mol% or more. Among these, a polymer or copolymer having (1) the residue of a dicarboxylic acid or an ester-forming derivative thereof and the residue of a diol or an ester-forming derivative thereof as a main structural unit is preferred from the viewpoint of achieving more excellent mechanical properties and heat resistance.

Examples of the dicarboxylic acid or the ester-forming derivative thereof include aromatic dicarboxylic acids such as terephthalic acid, isophthalic acid, phthalic acid, 2,6-naphthalene dicarboxylic acid, 1,5-naphthalene dicarboxylic acid, bis(p-carboxyphenyl)methane, 1,4-anthracene dicarboxylic acid, 1,5-anthracene dicarboxylic acid, 1,8-anthracene dicarboxylic acid, 2,6-anthracene dicarboxylic acid, 9,10-anthracene dicarboxylic acid, 4,4'-diphenyl ether dicarboxylic acid, tetrabutylphosphonium 5-isophthalate, and sodium 5-sulfoisophthalate; aliphatic dicarboxylic acids such as oxalic acid, succinic acid, adipic acid, sebacic acid, azelaic acid, dodecanedioic acid, malonic acid, glutaric acid, and dimer acid; alicyclic dicarboxylic acids such as 1,3-cyclohexanedicarboxylic acid and 1,4-cyclohexanedicarboxylic acid; and ester-

forming derivatives thereof. Two or more of these may be used.

Examples of the diol or the ester-forming derivative thereof include aliphatic or alicyclic glycols having 2 to 20 carbon atoms such as ethylene glycol, propylene glycol, 1,4-butanediol, neopentyl glycol, 1,5-pentanediol, 1,6-hexanediol, decamethylene glycol, cyclohexanedimethanol, cyclohexanediol, and dimer diol; long-chain glycols having a molecular weight of 200 to 100,000 such as polyethylene glycol, poly-1,3-propylene glycol, and polytetramethylene glycol; aromatic dioxy compounds such as 4,4'-dihydroxybiphenyl, hydroquinone, t-butylhydroquinone, bisphenol A, bisphenol S, and bisphenol F; and ester-forming derivatives thereof. Two or more of these may be used.

Examples of the polymer or copolymer having a dicarboxylic acid or an ester-forming derivative thereof and a diol or an ester-forming derivative thereof as a structural unit include aromatic polyester resins such as polyethylene terephthalate, polypropylene terephthalate, polybutylene terephthalate, polypropylene isophthalate, polybutylene isophthalate, polybutylene naphthalate, polypropylene isophthalate/terephthalate, polybutylene isophthalate/terephthalate, polypropylene terephthalate/naphthalate, polybutylene terephthalate/naphthalate, polybutylene terephthalate/decane dicarboxylate, polypropylene terephthalate/sodium 5-sulfoisophthalate, polybutylene terephthalate/sodium 5-sulfoisophthalate, polypropylene terephthalate/polyethylene glycol, polybutylene terephthalate/polyethylene glycol, polypropylene terephthalate/polytetramethylene glycol, polybutylene terephthalate/polytetramethylene glycol, polypropylene terephthalate/isophthalate/polytetramethylene glycol, polybutylene terephthalate/isophthalate/polytetramethylene glycol, polybutylene terephthalate/succinate, polypropylene terephthalate/adipate, polybutylene terephthalate/adipate, polypropylene terephthalate/sebacate, polybutylene terephthalate/sebacate, polypropylene terephthalate/isophthalate/adipate, polybutylene terephthalate/isophthalate/succinate, polybutylene terephthalate/isophthalate/adipate, and polybutylene terephthalate/isophthalate/sebacate. One of these polymers and copolymers may be used singly, or two or more may be used in combination. Here, "/" represents a copolymer.

Among these, from the viewpoint of further improving mechanical properties and heat resistance, a polymer or copolymer having a residue of an aromatic dicarboxylic acid or an ester-forming derivative thereof and a residue of an aliphatic diol or an ester-forming derivative thereof as a main structural unit is more preferred, and a polymer or copolymer having a residue of an aromatic dicarboxylic acid selected from terephthalic acid and naphthalene dicarboxylic acid, or an ester-forming derivative thereof and a residue of an aliphatic diol selected from propylene glycol and 1,4-butanediol, or an ester-forming derivative thereof as a main structural unit is still more preferred.

Among them, at least one aromatic polyester resin selected from polyethylene terephthalate, polypropylene terephthalate, polybutylene terephthalate, polypropylene naphthalate, polybutylene naphthalate, polypropylene isophthalate/terephthalate, polybutylene isophthalate/terephthalate, polypropylene terephthalate/naphthalate, polybutylene adipate/terephthalate, polybutylene terephthalate/sebacate, polybutylene terephthalate/naphthalate, and the like is especially preferable, and at least one selected from polyethylene terephthalate, polybutylene terephthalate, polybutylene isophthalate/terephthalate, polybutylene decane dicarboxylate/terephthalate, polybutylene terephthalate/-naphthalate, and polybutylene/ethylene terephthalate is more preferable. Polybutylene terephthalate is more preferable from the viewpoint of excellent balance between mechanical properties and molding processability. In addition, two or more kinds of them can be used at arbitrary contents, but polybutylene terephthalate is preferably used as a main component. Here, the "main component" means that 50 wt% or more of the thermoplastic polyester resin (A) blended in the resin composition is polybutylene terephthalate.

The carboxyl group concentration of the thermoplastic polyester resin (A) used in the present invention is preferably 50 eq/t or less from the viewpoints of suppression of deterioration of mechanical properties during melt kneading and residence, and moldability. The lower limit value of the carboxyl group concentration is 0 eq/t. Here, the carboxyl group concentration in the thermoplastic polyester resin (A) is a value measured by dissolving the thermoplastic polyester resin (A) in an o-cresol/chloroform solvent, and then titrating the resulting solution with ethanolic potassium hydroxide.

The thermoplastic polyester resin (A) used in the present invention preferably has a weight average molecular weight (Mw) of 8000 or more, from the viewpoint of further improving mechanical properties. When the weight average molecular weight (Mw) is 500,000 or less, fluidity can be improved, which is preferable. The weight average molecular weight (Mw) is more preferably 300,000 or less, still more preferably 250,000 or less. In the present invention, the weight average molecular weight (Mw) of the thermoplastic polyester resin (A) is a value in terms of polymethyl methacrylate (PMMA) measured by gel permeation chromatography (GPC) using hexafluoroisopropanol as a solvent.

The intrinsic viscosity of the thermoplastic polyester resin (A) used in the present invention is preferably 0.36 dL/g or more, more preferably 0.50 dL/g or more when the o-chlorophenol solution is measured at 25°C from the viewpoint of further improving mechanical properties. In addition, the intrinsic viscosity is preferably 1.60 dL/g or less, more preferably 1.50 dL/g or less from the viewpoint of being able to improve the fluidity.

The thermoplastic polyester resin (A) used in the present invention can be produced by a polycondensation method, a ring-opening polymerization method, or the like, which is well known. The production method may be either batch polymerization or continuous polymerization, and either transesterification reaction or direct polymerization may be employed in the reaction. From the viewpoint of productivity, continuous polymerization is preferable, and direct

polymerization is more preferably used.

When the thermoplastic polyester resin (A) used in the present invention is a polymer or copolymer that is obtained by a condensation reaction and has a dicarboxylic acid or an ester-forming derivative thereof and a diol or an ester-forming derivative thereof as main components, the thermoplastic polyester resin (A) can be produced by subjecting the dicarboxylic acid or an ester-forming derivative thereof and the diol or an ester-forming derivative thereof to esterification reaction or transesterification reaction followed by performing polycondensation reaction.

In the resin composition of the present invention, the content of the thermoplastic polyester resin (A) is preferably 30 to 99.9 wt% with respect to the total resin composition of the present invention. In cases where the content of the thermoplastic polyester resin (A) is less than 30 wt%, light weight and molding processability of the composition are deteriorated. The content is more preferably 50 wt% or more, still more preferably 60 wt% or more.

The thermoplastic polyester resin composition of the present invention further contains a carbon nanotube. By containing the carbon nanotube, electromagnetic wave absorbing properties can be improved while the mechanical strength of the resin composition is improved.

The carbon nanotube used in the present invention is a carbon nanotube (B) having a high-temperature-side combustion peak of 650°C to 900°C in thermogravimetric analysis upon heating in air at 10°C/min (which may be hereinafter referred to as "carbon nanotube (B)"). In cases where the combustion peak temperature is lower than 650°C, carbon impurities (other than the carbon nanotube) and a catalyst are contained in the carbon nanotube, so that the electromagnetic wave absorbing properties and the mechanical properties of the resin composition are deteriorated. The combustion peak temperature is preferably 670°C or more, more preferably 680°C or more. In cases where the combustion peak temperature exceeds 900°C, the crystallinity of the carbon nanotube is excessively high, so that the dispersibility of the carbon nanotube in the polyester resin composition decreases, resulting in decreased electromagnetic wave absorbing properties. The combustion peak temperature is preferably 850°C or less, more preferably 800°C or less. The combustion peak temperature is calculated by the following method. By subjecting the carbon nanotube to measurement by thermogravimetric analysis, and differentiating the weight loss curve with respect to time, a differential thermogravimetry (DTG) curve was obtained. Subsequently, a graph of the differential thermogravimetric analysis (DTG) curve is prepared by plotting the temperature (°C) on the x-axis and DTG (mg/min) on the y-axis, and the peak temperature in the DTG curve is determined as the combustion peak temperature. In the DTG curve of the carbon nanotube, two or more peak temperatures may appear. In this case, in the present invention, the peak temperature on the highest-temperature side is taken as the combustion peak temperature. In cases where only one peak temperature is observed in the DTG curve, that peak temperature is regarded as the peak temperature on the high-temperature side.

In general, carbon impurities burn at 400°C or less, but when they are attached to a carbon nanotube, the combustion temperature of the carbon impurities tends to shift to the high-temperature side. On the other hand, a carbon nanotube to which carbon impurities are attached shows a combustion peak temperature shifting to the low-temperature side as compared with the original combustion peak temperature of the carbon nanotube. The reason is as follows. Since the combustion temperature of the carbon impurities is lower than the combustion temperature of the carbon nanotube, the carbon impurities start combustion first, and the heat energy generated at that time moves to the carbon nanotube. As a result, the carbon nanotube burns at a temperature lower than the original combustion temperature. Therefore, the higher the degree of graphitization of the carbon nanotube and the smaller the amount of carbon impurities, the more the combustion peak temperature shifts to the high-temperature side, so that a higher combustion peak temperature indicates that the carbon nanotube has higher purity. In cases where the carbon nanotube has a combustion peak temperature within the above-described range, the resin composition can exhibit high electromagnetic wave absorbing properties even when the content of the carbon nanotube is small, so that the volume resistivity in the resin composition can be kept low, and the laser marking property can be improved as a result.

The average diameter of the carbon nanotubes (B) used in the present invention is not particularly limited, and is preferably 1000 nm or less, more preferably 300 nm or less, especially preferably 100 nm or less. When the average diameter is 1000 nm or less, dielectric loss is likely to occur, and the electromagnetic wave absorbing properties can be further improved. The average diameter of the carbon nanotube (B) is preferably 0.1 nm or more, more preferably 0.5 nm or more, especially preferably 1.0 nm or more. When the average diameter is 0.1 nm or more, bundles are less likely to be formed, and fine dispersion is likely to occur in the resin composition, so that the mechanical strength and the electromagnetic wave absorbing properties can be further improved. Regarding the average diameter, carbon nanotubes (B) were observed under a transmission electron microscope, and the diameters of 100 or more carbon nanotubes (B) were measured, followed by calculating their average. Since the carbon nanotube (B) is a substance having a large aspect ratio, the diameter of the cross-section perpendicular to the longitudinal direction of the shape was taken as the diameter.

The content of the carbon nanotube (B) in the resin composition of the present invention is 0.1 to 5 parts by weight with respect to 100 parts by weight of the thermoplastic polyester resin (A). When the content of the carbon nanotube (B) is less than 0.1 parts by weight, the electromagnetic wave absorbing properties are deteriorated. The content is preferably 0.3 parts by weight or more, more preferably 0.5 parts by weight or more. In addition, when the content of the carbon nanotube (B) exceeds 5 parts by weight, the volume resistivity decreases, and the laser marking property is deteriorated.

The content is preferably 4 parts by weight or less, more preferably 3 parts by weight or less.

Further, as long as the object of the present invention is not impaired, a carbon filler other than the carbon nanotube (B) may be added.

The thermoplastic polyester resin composition of the present invention preferably further contains a fibrous reinforcing material (C). By containing the fibrous reinforcing material (C), the mechanical strength of the molded article can be improved. Examples of the fibrous reinforcing material (C) include glass fibers, aramid fibers, and cellulose fibers, and among them, glass fibers can be preferably used.

The fibrous reinforcing material (C) used in the present invention may have a circular cross-section or a flat cross-section. It is also possible to use hollow fibers for the purpose of, for example, reducing the specific gravity. As the cross-sectional area of the fibrous reinforcing material (C) increases, a sufficient reinforcing effect becomes more difficult to obtain. On the other hand, when the cross-sectional area is too small, production of the fibrous reinforcing material becomes difficult, and its handling may also become difficult. The cross-sectional area of the fibrous reinforcing material (C) is preferably $2 \times 10^{-5}$ to $8 \times 10^{-3}$ $mm^2$, more preferably $8 \times 10^{-5}$ to $8 \times 10^{-3}$ $mm^2$, still more preferably $8 \times 10^{-5}$ to $8 \times 10^{-4}$ $mm^2$.

In the fibrous reinforcing material (C) used in the present invention, it is preferable to use a sizing agent or a surface treatment agent as necessary. Examples of the sizing agent or the surface treatment agent include functional compounds such as an epoxy compound, an isocyanate compound, and a silane compound. These compounds may be used in advance for surface-treating or sizing the fibrous reinforcing material or added simultaneously with the fibrous reinforcing material during preparation of the resin composition.

The content of the fibrous reinforcing material (C) in the resin composition of the present invention is preferably 1 part by weight to 100 parts by weight with respect to 100 parts by weight of the thermoplastic polyester resin (A). When the content of the fibrous reinforcing material (C) is 1 part by weight or more, the mechanical strength of the molded article can be further improved. The content is preferably 10 parts by weight or more, more preferably 20 parts by weight or more. When the content of the fibrous reinforcing material (C) is 100 parts by weight or less, a decrease in the fluidity can be suppressed. The content is preferably 80 parts by weight or less, more preferably 50 parts by weight or less.

It is preferable that the thermoplastic polyester resin composition of the present invention further contain a vinyl copolymer (D) (which may be hereinafter referred to as "component (D)"). By containing the vinyl copolymer (D), which has lower thermal conductivity than the thermoplastic polyester resin, diffusion of heat through the carbon nanotube (B) can be suppressed, and the laser marking property can be improved. Further, since the dispersibility of the carbon nanotube (B) is improved, the electromagnetic wave absorbing properties of the molded article can be further improved. The vinyl copolymer (D) used in the present invention is preferably a copolymer containing at least an unsaturated nitrile monomer and an aromatic vinyl monomer as copolymerization components. Other copolymerizable monomers may also be copolymerized as necessary. In general, these vinyl copolymers (D) are produced by emulsion polymerization, bulk polymerization, or bulk/suspension polymerization, but are not limited thereto.

The unsaturated nitrile monomer used for the vinyl copolymer (D) is not particularly limited, and examples thereof include acrylonitrile, methacrylonitrile, and ethacrylonitrile, and among them, acrylonitrile is preferable. The aromatic vinyl monomer is not particularly limited, and specific examples thereof include not only styrene, but also $\alpha$-methylstyrene, o-methylstyrene, p-methylstyrene, o-ethylstyrene, p-ethylstyrene, and p-t-butylstyrene, and among them, styrene and $\alpha$-methylstyrene are preferably used. Examples of other copolymerizable monomers include acrylic acid and methacrylic acid ester compounds such as butyl acrylate, ethyl acrylate, and methyl methacrylate; N-phenylmaleimide, and maleic anhydride. Among them, a styrene-acrylonitrile copolymer (hereinafter abbreviated as AS resin) containing: a total of 85 mass% or more of acrylonitrile as an unsaturated nitrile monomer and styrene as an aromatic vinyl monomer; and 15 mass% or less of other copolymerizable monomers; as copolymerization components is preferable.

The vinyl copolymer (D) may contain a rubbery polymer as long as scratch resistance is not largely deteriorated. A resin obtained by grafting an unsaturated nitrile monomer and an aromatic vinyl monomer to the rubbery polymer, and a resin obtained by further copolymerizing another copolymerizable monomer are also included. Monomers similar to the monomers shown above can be used as the unsaturated nitrile monomer, aromatic vinyl monomer, and other copolymerizable monomers to be used. The rubbery polymer used for the vinyl copolymer (D) is not particularly limited, but diene rubber, acrylic rubber, ethylene rubber, and the like can be used. Specific examples of these rubbery polymers include polybutadiene, a styrene-butadiene copolymer, a block copolymer of styrene-butadiene, an acrylonitrile-butadiene copolymer, a butyl acrylate-butadiene copolymer, polyisoprene, a butadiene-methyl methacrylate copolymer, a butyl acrylate-methyl methacrylate copolymer, a butadiene-ethyl acrylate copolymer, an ethylene-propylene copolymer, an ethylene-propylene-diene-based copolymer, an ethylene-isoprene copolymer, and an ethylene-methyl acrylate copolymer. Among these rubbery polymers, an acrylic rubber is preferably used.

In addition, the vinyl copolymer (D) is also preferably copolymerized with a raw material monomer forming a glycidyl group-containing vinyl-based unit in order to improve compatibility with the thermoplastic polyester resin (A). Specific examples of the raw material monomer forming the glycidyl group-containing vinyl-based unit include glycidyl esters of unsaturated monocarboxylic acids such as glycidyl (meth)acrylate and glycidyl p-styrylcarboxylate; mono-

glycidyl esters or polyglycidyl esters of unsaturated polycarboxylic acids such as maleic acid and itaconic acid; and unsaturated glycidyl ethers such as allyl glycidyl ether, 2-methylallyl glycidyl ether, and styrene-4-glycidyl ether.

The content of the vinyl copolymer (D) in the resin composition of the present invention is preferably 1 part by weight to 100 parts by weight with respect to 100 parts by weight of the thermoplastic polyester resin (A). When the content of the vinyl copolymer (D) is 1 part by weight or more, the dimensional stability is improved, so that the electromagnetic wave absorbing properties of the molded article can be stabilized regardless of the molding conditions. The content is preferably 10 parts by weight or more, more preferably 20 parts by weight or more. When the content of the vinyl copolymer (D) is 100 parts by weight or less, deterioration of heat resistance can be suppressed. The content is preferably 80 parts by weight or less, more preferably 50 parts by weight or less.

It is preferable that the thermoplastic polyester resin composition of the present invention further contain an ethylene/alkyl acrylate copolymer (E) (which may be hereinafter referred to as "component (E)"). By containing the ethylene/alkyl acrylate copolymer (E), which has lower thermal conductivity than the thermoplastic polyester resin, diffusion of heat through the carbon nanotube (B) can be suppressed, and the laser marking property can be improved. Further, since the dispersibility of the carbon nanotube (B) is improved, the electromagnetic wave absorbing properties of the molded article can be further improved. The ethylene/alkyl acrylate copolymer (E) is preferably an $\alpha$-olefin and an $\alpha,\beta$-ethylenically unsaturated carboxylic acid or a derivative thereof, or a glycidyl group-containing terpolymer composed of an $\alpha$-olefin, an $\alpha,\beta$-ethylenically unsaturated carboxylic acid or a derivative thereof, and a glycidyl ester of an $\alpha,\beta$-unsaturated acid. Specific examples of the ethylene/alkyl acrylate copolymer (E) include an ethylene/methyl acrylate copolymer, an ethylene/ethyl acrylate copolymer, an ethylene/butyl acrylate copolymer, an ethylene/methacrylic acid copolymer, an ethylene/glycidyl copolymer, an ethylene/methacrylic acid/glycidyl copolymer, an ethylene/vinyl acetate/glycidyl methacrylate copolymer, an ethylene/ethyl acrylate-g-methyl methacrylate/butyl acrylate copolymer, and an ethylene/ethyl acrylate-g-methyl methacrylate copolymer. These may be used individually or in the form of a mixture.

By blending the ethylene/alkyl acrylate copolymer (E) in the thermoplastic polyester resin (A), the fluidity and the toughness of the thermoplastic polyester resin (A) composition can be improved. However, when the glycidyl group-containing terpolymer composed of an $\alpha$-olefin, an $\alpha,\beta$-ethylenically unsaturated carboxylic acid or a derivative thereof, and a glycidyl ester of an $\alpha,\beta$-unsaturated acid is used alone, a glycidyl group in the ethylene/alkyl acrylate copolymer reacts with the thermoplastic polyester resin (A), and therefore the fluidity and the residence stability tend to decrease. Therefore, from the viewpoint of imparting fluidity and toughness, it is preferred to include the combination of: a copolymer of an $\alpha$-olefin and an $\alpha,\beta$-ethylenically unsaturated carboxylic acid or a derivative thereof; and a glycidyl group-containing terpolymer composed of an $\alpha$-olefin, an $\alpha,\beta$-ethylenically unsaturated carboxylic acid or a derivative thereof, and a glycidyl ester of an $\alpha,\beta$-unsaturated acid. It is more preferred to include an $\alpha$-olefin and an $\alpha,\beta$-ethylenically unsaturated carboxylic acid or a derivative thereof alone.

The content of the ethylene/alkyl acrylate copolymer (E) is preferably1 part by weight to 20 parts by weight with respect to 100 parts by weight of the thermoplastic polyester resin (A). When the content of the ethylene/alkyl acrylate copolymer (E) is 1 part by weight or more, diffusion of heat via the carbon nanotube (B) can be suppressed; the laser marking property can be improved; and furthermore, because the dispersibility of the carbon nanotube (B) is improved, the electromagnetic wave absorbing properties of the molded article can be further improved. The content is preferably 3 parts by weight or more, and more preferably 5 parts by weight or less. Further, when the content of the (E) ethylene/alkyl acrylate copolymer is 20 parts by weight or less, the laser marking property and the electromagnetic wave absorbing properties of the molded article can be further improved without deteriorating the rigidity and the fluidity of the polyethylene resin. The content is preferably 15 parts by weight or less, more preferably 10 parts by weight or less.

The thermoplastic polyester resin composition of the present invention preferably further contains a compound (F) having in each molecule two or more functional groups capable of reacting with a carboxyl group (which may be hereinafter referred to as "compound (F)"). By blending the compound (F), the dispersibility of the carbon nanotube is improved, and the electromagnetic wave absorbing properties are improved. In the thermoplastic polyester resin (A), decomposition of ester bonds occurs due to hydrolysis, and as a result, the carboxyl group concentration in the resin increases. As the carboxyl group concentration increases, reduction in the molecular weight of the thermoplastic polyester resin (A) is promoted, and the mechanical properties are deteriorated. In the present invention, in cases where the compound (F) is blended together with the thermoplastic polyester resin (A), a carboxyl group of the thermoplastic polyester resin (A) generated by hydrolysis reacts with a functional group of the compound (F) to suppress an increase in the carboxyl group concentration. As a result, high mechanical properties of the thermoplastic polyester resin (A) can be maintained.

Examples of the compound (F) include an epoxy compound, an oxazoline compound, and a carbodiimide compound.

The epoxy compound is a compound having an epoxy group as a functional group capable of reacting with a carboxyl group. The epoxy compound is not particularly limited as long as it has two or more epoxy groups in one molecule. Examples of the epoxy compound having two or more epoxy groups in one molecule include a glycidyl ether type epoxy resin, a glycidyl ester type epoxy resin, a glycidylamine type epoxy resin, an alicyclic epoxy resin, and a heterocyclic epoxy

resin. They may be used singly or in combination of two or more thereof.

Examples of the glycidyl ether type epoxy resin include a condensate of a phenol compound and epichlorohydrin, novolac type epoxy, and a glycidyl ether of a polyhydric alcohol compound.

Specific examples of the condensate of a phenol compound and epichlorohydrin include condensates obtained by condensation of epichlorohydrin with phenol compounds such as bisphenol A, resorcinol, hydroquinone, pyrocatechol, bisphenol F, saligenin, bisphenol S, 4,4'-dihydroxybiphenyl, 1,5-dihydroxynaphthalene, 1,4-dihydroanthracene-9,10-diol, 6-hydroxy-2-naphthoic acid, 1,1-methylenebis-2,7-dihydroxynaphthalene, 1,1,2,2-tetrakis-4-hydroxyphenylethane, and cashew phenol.

Specific examples of the novolac type epoxy include phenol novolac type epoxy, cresol novolac type epoxy, naphthol novolac type epoxy, bisphenol A novolac type epoxy, dicyclopentadiene-phenol-added novolac type epoxy, dimethylenephenylene-phenol-added novolac type epoxy, and dimethylenebiphenylene-phenol-added novolac type epoxy.

The polyhydric alcohol compound is an aliphatic compound having 2 or more hydroxy groups, and specific examples thereof include glycols having 2 to 20 carbon atoms, glycerin, polyglycerin, dipentaerythritol, tripentaerythritol, xylitol, mannitol, sorbitol, galactose, maltitol, lactitol, isomalt, inositol, glucose, and fructose.

Examples of the glycidyl ester type epoxy resin include epoxy resins produced from epichlorohydrin and phthalic acid, tetrahydrophthalic acid, p-oxybenzoic acid, or dimer acid, trimesic acid triglycidyl ester, trimellitic acid triglycidyl ester, pyromellitic acid tetraglycidyl ester, epoxidized fatty acid octyl ester, epoxidized soybean oil, and epoxidized linseed oil.

Examples of the glycidylamine type epoxy resin include epoxy resins produced from epichlorohydrin and aniline, diaminodiphenylmethane, p-aminophenol, meta-xylylenediamine, or 1,3-bis(aminomethyl)cyclohexane, tetraglycidylaminodiphenylmethane, triglycidyl-para-aminophenol, triglycidyl-meta-aminophenol, tetraglycidyl-meta-xylenediamine, tetraglycidylbisaminomethylcyclohexane, triglycidyl cyanurate, and triglycidyl isocyanurate.

Examples of the alicyclic epoxy resin include compounds having a cyclohexene oxide group, a tricyclodecene oxide group, and a cyclopentene oxide group.

Examples of the heterocyclic epoxy resin include epoxy resins produced from epichlorohydrin and hydantoin or isocyanuric acid.

Among them, a glycidyl ether type epoxy resin is preferable from the viewpoint of suppressing a reaction between epoxy groups of the compound (F) and suppressing deterioration of the residence stability.

The oxazoline compound is a compound having an oxazoline group as a functional group capable of reacting with a carboxyl group. Specific examples of the oxazoline compound include compounds having an oxazoline group as a functional group capable of reacting with a carboxyl group, such as 2,2'-bis(2-oxazoline), 2,2'-ethylene-bis(4,4'-dimethyl-2-oxazoline), 2,2'-p-phenylene-bis(2-oxazoline), and bis(2-oxazolinylcyclohexane) sulfide, and oxazoline group-containing polymers. These can be used singly or in combination of two or more kinds thereof. Among them, an oxazoline group-containing polymer is preferable from the viewpoint of ease of handling. The oxazoline group-containing polymer is obtained by addition polymerizable oxazoline polymerization of 2-vinyl-2-oxazoline, 2-vinyl-4-methyl-2-oxazoline, 2-isopropenyl-2-oxazoline, or the like. Other monomers may be copolymerized as necessary. The polymerization method of the oxazoline group-containing polymer is not particularly limited, and various known polymerization methods can be adopted.

The carbodiimide compound is a compound having a carbodiimide group as a functional group capable of reacting with a carboxyl group. Specific examples of the carbodiimide compound include dicarbodiimides such as N,N'-diisopropylcarbodiimide, N,N'-dicyclohexylcarbodiimide, and N,N'-di-2,6-diisopropylphenylcarbodiimide; and polycarbodiimides such as poly(1,6-hexamethylenecarbodiimide), poly(4,4'-methylenebiscyclohexylcarbodiimide), poly(1,3-cyclohexylenecarbodiimide), poly(1,4-cyclohexylenecarbodiimide), poly(4,4'-dicyclohexylmethanecarbodiimide), poly(4,4'-diphenylmethanecarbodiimide), poly(3,3'-dimethyl-4,4'-diphenylmethanecarbodiimide), poly(naphthalenecarbodiimide), poly(p-phenylenecarbodiimide), poly(m-phenylenecarbodiimide), poly(tolylcarbodiimide), poly(diisopropylcarbodiimide), poly(methyl-diisopropylphenylenecarbodiimide), poly(1,3,5-triisopropylbenzene)polycarbodiimide, poly(1,3,5-triisopropylbenzene)polycarbodiimide, poly(1,5-diisopropylbenzene) polycarbodiimide, poly(triethylphenylenecarbodiimide), and poly(triisopropylphenylenecarbodiimide).

Among these, an epoxy compound having an epoxy group as a functional group capable of reacting with a carboxyl group is more preferable from the viewpoint that the epoxy compound also reacts with the hydroxy group terminal of the thermoplastic polyester resin (A), post-crystallization at the time of hydrolysis of the resin composition can be suppressed, and the hydrolysis resistance can be further improved.

In the present invention, even when the vinyl copolymer (D) or the ethylene/alkyl acrylate copolymer (E) is obtained by copolymerizing raw material monomers containing a reactive functional group such as a glycidyl group and also corresponds to the compound (F), the copolymer is treated as the component (D) or the component (E), respectively.

In the thermoplastic polyester resin composition of the present invention, the content of the compound (F) is preferably 0.1 parts by weight to 10 parts by weight with respect to 100 parts by weight of the thermoplastic polyester resin (A). When the content of the compound (F) is 0.1 parts by weight or more, the dispersibility of the carbon nanotube in the

resin composition is improved; the electromagnetic wave absorbing properties are improved; and the hydrolysis resistance can be improved. The content is more preferably 0.3 parts by weight or more, still more preferably 0.5 parts by weight or more, especially preferably 1.0 part by weight or more. On the other hand, when the content of the compound (F) is 10 parts by weight or less, thickening of the polyester resin composition can be suppressed, and the radio wave absorbing properties and the hydrolysis resistance can be improved without deteriorating the fluidity. The content is more preferably 8 parts by weight or less, still more preferably 5 parts by weight or less.

When a 3 mm-thick square plate formed by molding the thermoplastic polyester resin composition of the present invention is subjected to measurement by a free space method in a band of 60 to 90 GHz, the composition preferably shows a reflection loss S11 of -3 dB or less and a transmission loss S21 of -20 dB or less. When the reflection loss S11 has a value greater than -3 dB, radio waves reflected at the surface of the resin molded article cannot be attenuated, and when the reflected radio waves are reflected again by a certain member, electronic devices in the resin molded article may be adversely affected. The reflection loss S11 is preferably -4 dB or less, more preferably -5 dB or less. Further, when the transmission loss S21 has a value greater than -20 dB, electromagnetic wave shielding properties for electronic devices in the resin molded article are insufficient, and hence the electronic devices in the resin molded article may be adversely affected. The transmission loss S21 is preferably -25 dB or less, more preferably -30 dB or less. Furthermore, when the reflection loss S11 and the transmission loss S21 are less than -80 dB, the conductivity of the polyester resin composition becomes excessively high, and therefore the laser marking property is deteriorated. Therefore, both the reflection loss S11 and the transmission loss S21 are preferably -80 dB or more.

By blending 0.1 parts by weight or more of the carbon nanotube (B) with respect to 100 parts by weight of the thermoplastic polyester resin (A), the reflection loss S11 can be set to -3 dB or less, and the transmission loss S21 can be set to -20 dB or less.

The thermoplastic polyester resin composition of the present invention preferably has a volume resistivity of $1.0 \times 10^5\ \Omega\cdot m$ to $1.0 \times 10^{15}\ \Omega\cdot m$. By setting the volume resistivity to $1.0 \times 10^5\ \Omega\cdot m$ or more, thermal diffusion, which has a correlation with the volume resistivity, can be suppressed, so that foaming of the thermoplastic polyester resin by laser light can be efficiently carried out, and the laser marking property can be improved. A volume resistivity of $1.0 \times 10^7\ \Omega\cdot m$ or more is more preferred because insulating properties can be imparted to the thermoplastic polyester resin composition. Further, from the viewpoint of efficiently allowing the composition to exhibit electromagnetic wave absorbing properties, the volume resistivity is preferably $1.0 \times 10^{15}\ \Omega\cdot m$ or less.

By setting the content of the carbon nanotube (B), which is conductive, to 5 parts by weight or less with respect to 100 parts by weight of the thermoplastic polyester resin (A), the value of the volume resistivity of the polyester resin composition can be set within a preferred range.

In the thermoplastic polyester resin composition of the present invention, a thermoplastic resin other than the component (A) may be contained to an extent at which the object of the present invention is not impaired, so as to improve moldability, toughness, and the like. Examples of the thermoplastic resin other than the component (A) include a polyamide resin, a polyacetal resin, a polyurethane resin, an aromatic or aliphatic polyketone resin, a polyphenylene sulfide resin, a polyether ether ketone resin, a polyimide resin, a thermoplastic starch resin, a polyarylate resin, a polysulfone resin, a polyether sulfone resin, a phenoxy resin, a polyphenylene ether resin, a polyether imide resin, a cellulose acetate resin, and a polyvinyl alcohol resin.

Furthermore, the thermoplastic polyester resin composition of the present invention may contain other components, for example, a stabilizer, a weathering agent (resorcinol type, salicylate type, benzophenone type, and the like), a lubricant (montanic acid and esters thereof, half esters thereof, stearyl alcohol, polyethylene wax, and the like), a pigment, a dye, a crystal nucleating agent (talc, polyether ether ketone, and the like), a plasticizer, an antistatic agent, a flame retardant, an anti-discoloration agent, other polymers, and the like as long as the object of the present invention is not impaired.

The thermoplastic polyester resin composition of the present invention can be obtained, for example, by melt-kneading the thermoplastic polyester resin (A) and the carbon nanotube (B), and as necessary, other components.

Examples of the melt kneading method include a method in which the thermoplastic polyester resin (A), the carbon nanotube (B), various additives, and the like are preliminarily mixed and supplied to an extruder or the like followed by sufficiently melt-kneading the resulting mixture, and a method in which each component is supplied to an extruder or the like while the component is weighed using a fixed amount feeder such as a weight feeder such that a predetermined composition is obtained, followed by sufficiently melt-kneading the resulting mixture.

Examples of the preliminary mixing include a dry blending method and a mixing method using mechanical mixing devices such as a tumbler, a ribbon mixer, and a Henschel mixer.

Further, the carbon nanotube (B) can be used as a carbon nanotube masterbatch prepared by preliminarily dispersing the carbon nanotube (B) at high concentration in a thermoplastic resin. The use of the carbon nanotube masterbatch is preferable from the viewpoint of handleability and uniform dispersibility of the carbon nanotube. In this case, the thermoplastic resin to be used for the masterbatch of the carbon nanotube may be the thermoplastic polyester resin as the component (A) or may be a resin other than the component (A), such as a polyamide resin, a polycarbonate

resin, a styrene-based resin, or a polyethylene resin. From the viewpoint of easily dispersing a high concentration of the carbon nanotube (B) and easily forming the masterbatch, it is preferable to form the masterbatch using the thermoplastic polyester resin (A).

When the melt kneading is carried out using a multi-screw extruder such as a twin-screw extruder, the fibrous reinforcing material (C) may be added through a side feeder installed between the feeding portion and the vent portion.

In the case of a liquid additive, a method of adding the liquid additive by installing a liquid injection nozzle between the feeding portion and the vent portion of a multi-screw extruder such as a twin-screw extruder and using a plunger pump or a method of supplying the liquid additive using a metering pump from the feeding portion or the like may be used.

The thermoplastic polyester resin composition of the present invention is preferably pelletized, and then subjected to molding processing using the resulting pellet. Examples of the pelletization method include a method of discharging the components constituting the resin composition using a single-screw extruder, a twin-screw extruder, a three-screw extruder, a conical extruder, a kneader type mixer, or the like into the form of strands, and then cutting the resulting strands using a strand cutter to obtain pellets.

The molded article of the present invention is obtained by molding the thermoplastic polyester resin composition of the present invention. By melt-molding the thermoplastic polyester resin composition of the present invention, molded articles in the forms of a film, fiber, and other various types of shapes can be obtained. Examples of the melt-molding method include injection molding, extrusion molding, and blow molding, and injection molding is particularly preferably used.

In addition to a regular injection molding method, other types of injection molding methods are also known such as gas-assist molding, two-color molding, sandwich molding, in-mold molding, insert molding, and injection press molding, and any of the molding methods can also be applied.

The thermoplastic polyester resin composition of the present invention has high electromagnetic wave absorbing properties, excellent mechanical strength, and excellent laser marking property. The molded article of the present invention is a molded article excellent in electromagnetic wave absorbing properties, mechanical properties, and hydrolysis resistance and can be used for various applications such as automobile components, mechanical mechanism components, and electric and electronic components utilizing the characteristics thereof.

Specific applications include junction boxes, LiBs, insulators, air flow meters, air pumps, thermostat housings, engine mounts, ignition bobbins, ignition cases, clutch bobbins, idle speed control valves, vacuum switching valves, ECU housings, HUD housings, vacuum pump cases, inhibitor switches, rotation sensors, pressure sensors, acceleration sensors, millimeter wave radars, housings of sensing components such as ultrasonic sensors, brackets and internal components thereof, automotive under-hood parts such as distributor caps, coil bases, actuator cases for ABS, tops and bottoms of radiator tanks, cooling fans, fan shrouds, engine covers, cylinder head covers, oil caps, oil pans, oil filters, fuel caps, fuel strainers, distributor caps, vapor canister housings, air cleaner housings, timing belt covers, brake booster components, various cases, various tubes, various tanks, various hoses, various clips, various valves, and various pipes, automotive interior parts such as torque control levers, safety belt parts, register blades, washer levers, window regulator handles, window regulator handle knobs, passing light levers, sun visor brackets, and various motor housings; automotive exterior parts such as roof rails, fenders, garnishes, bumpers, door mirror stays, spoilers, hood louvers, wheel covers, wheel caps, grille apron cover frames, lamp reflectors, lamp bezels, and door handles; various automotive connectors such as wire harness connectors, SMJ connectors, PCB connectors, and door grommet connectors; and electrical connectors, relay cases, coil bobbins, optical pickup chassis, motor cases, notebook computer housings and internal components, CRT display housings and internal components, printer housings and internal components, housings and internal components of mobile terminals such as mobile phones, mobile personal computers, and handheld mobile devices, housings and internal components of recording medium (CD, DVD, PD, FDD, etc.) drives, housings and internal components of copiers, housings and internal components of facsimile machines, and housings and internal components of communication electrical and electronic components represented by base stations, data communication modules, various antennas, and the like. Further, home and office electrical appliance components represented by VTR components, television components, irons, hair driers, rice cooker components, microwave oven components, acoustic components, video cameras, video equipment components such as projectors, lighting components, refrigerator components, air conditioner components, typewriter components, word processor components, and the like can be mentioned. Examples also include housings and internal components of electronic musical instruments, home game machines, portable game machines, and the like, various gears, various cases, sensors, LED lamps, connectors, sockets, resistors, relay cases, switches, coil bobbins, capacitors, variable capacitor cases, optical pickups, radiators, and various terminal strips.

Among them, suitable applications include ECU housings, HUD housings, rotation sensors, pressure sensors, acceleration sensors, millimeter wave radars, housings of sensing components such as ultrasonic sensors, brackets and internal components thereof, notebook computer housings and internal components, CRT display housings and internal components, printer housings and internal components, housings and internal components of mobile terminals such as mobile phones, mobile personal computers, and handheld mobile devices, housings and internal components of

recording medium (CD, DVD, PD, FDD, etc.) drives, housings and internal components of copiers, housings and internal components of facsimile machines, housings and internal components of communication electric and electronic components represented by base stations, data communication modules, various antennas, and the like, which particularly require electromagnetic wave absorbing properties.

## EXAMPLES

Next, the present invention will be described in more detail with reference to examples, but these examples do not limit the present invention.

The abbreviations of the main raw materials used in the examples and the contents thereof are summarized below.

(A) Thermoplastic polyester resin

A-1: Polybutylene terephthalate (terminal carboxyl group concentration: 25 eq/t, intrinsic viscosity measured at 25°C using o-chlorophenol solution as solvent: 0.85 dL/g).
A-2: Polyethylene terephthalate (terminal carboxyl group concentration: 25 eq/t, intrinsic viscosity measured at 25°C using o-chlorophenol solution as solvent: 0.80 dL/g).

(B) Carbon Nanotube

B-1: Carbon nanotube A (average diameter: 12 nm, BET specific surface area: 265 $m^2$/g, composition: 95 mass% carbon, thermogravimetric analysis combustion peak temperature: 688°C)
B-2: Carbon nanotube B (average diameter: 15 nm, BET specific surface area: 205 $m^2$/g, composition: 98 mass% carbon, thermogravimetric analysis combustion peak temperature: 675°C)
B'-3: Carbon nanotube C (average diameter: 15 nm, BET specific surface area: 191 $m^2$/g, composition: 98 mass% carbon, thermogravimetric analysis combustion peak temperature: 647°C)
B'-4: Carbon nanotube D (average diameter: 9.5 nm, BET specific surface area: 275 $m^2$/g, composition: 90 mass% carbon, thermogravimetric analysis combustion peak temperature: 645°C)
B-5: Carbon nanotube masterbatch

Using a co-rotating twin-screw extruder with a vent (TEX30$\alpha$ manufactured by The Japan Steel Works, Ltd.) having a screw diameter of 30 mm and L/D of 35, 11.1 parts by weight of B-1 (carbon nanotube A) was melt-kneaded with 100 parts by weight of A-1 (polybutylene terephthalate) under the conditions of a cylinder temperature of 250°C and a screw rotation speed of 150 rpm. The melt-kneaded product was discharged into a strand shape, and cut with a strand cutter for pelletization. Thereafter, the obtained pellets were vacuum-dried at a temperature of 110°C for 6 hours to obtain carbon nanotube masterbatch pellets.

(C) Fibrous reinforcing material

C-1: Circular cross-section chopped strand glass fiber (ECS 03 T-187 manufactured by Nippon Electric Glass Co., Ltd.).

(D) Vinyl copolymer

D-1: Acrylonitrile/styrene/glycidyl methacrylate copolymer (weight ratio of components of acrylonitrile/styrene/glycidyl methacrylate copolymer: 23.7/76.0/0.3, reduced viscosity: 0.72).

(E) Ethylene/alkyl acrylate copolymer

E-1: Ethylene/methyl acrylate copolymer ("ELVALOY AC" (registered trademark) 22534 (trade name) manufactured by DuPont-Mitsui Polychemicals Co., Ltd.).

(F) Compound having in each molecule two or more functional groups capable of reacting with carboxyl group

F-1: Epoxy resin (HP7200H manufactured by DIC Corporation).

The evaluation methods used in examples and comparative examples are summarized below.

(1) Thermogravimetric analysis (combustion peak temperature of carbon nanotube)

Using a thermogravimetric analyzer (TGA-60 manufactured by Shimadzu Corporation), a sample was held at 150°C for 30 minutes in air and then heated from room temperature to 950°C at a heating rate of 10°C/min. The weight loss at that time was measured to obtain a weight loss curve. By differentiating the obtained weight loss curve with respect to time, a differential thermogravimetry (DTG) curve was obtained. A graph of the differential thermogravimetric analysis (DTG) curve was prepared by plotting the temperature (°C) on the x-axis and DTG (mg/min) on the y-axis, and the peak temperature in the DTG curve was taken as the combustion peak temperature. At this time, two or more peak temperatures may appear, but in the present invention, the peak temperature on the highest-temperature side was taken as the combustion peak temperature of the carbon nanotube.

(2) Tensile properties

Using an SE50-DUZ injection molding machine manufactured by Sumitomo Heavy Industries, Ltd., an ISO-1A dumbbell test piece for evaluation of tensile properties having a thickness of 4 mm was obtained by injection molding of the thermoplastic polyester resin (A). When the thermoplastic polyester resin (A) was polybutylene terephthalate, the injection molding was performed under the temperature conditions of a molding temperature of 260°C and a mold temperature of 80°C, and under the molding cycle conditions of a total of injection time and dwelling time of 10 seconds and a cooling time of 10 seconds. When the thermoplastic polyester resin (A) was polyethylene terephthalate, the injection molding was performed under the temperature conditions of a molding temperature of 280°C and a mold temperature of 120°C, and under the molding cycle conditions of a total of injection time and dwelling time of 20 seconds and a cooling time of 20 seconds. For the obtained test piece for evaluation of tensile properties, the maximum tensile strength point (tensile strength) was measured according to ISO 527-2: 2012 using a tensile tester (Autograph AG-50 kNX Plus) manufactured by Shimadzu Corporation. The average value of the measured values of three samples was taken as the value of the tensile strength. A material having a large value of tensile strength was judged to have excellent mechanical properties.

(3) Hydrolysis resistance

An ISO-1A dumbbell test piece for evaluation of tensile properties having a thickness of 4 mm was obtained under the same molding conditions as for the tensile properties in Section (2) using an SE50-DUZ injection molding machine manufactured by Sumitomo Heavy Industries, Ltd. The obtained test piece was placed for 50 hours in a highly accelerated life test chamber EHS-411 manufactured by ESPEC CORP. set at a temperature of 121°C and a humidity of 100% RH, to perform moist heat treatment. The test piece after the moist heat treatment was subjected to measurement of the maximum tensile strength point under the same conditions as for the tensile properties in Section (2), and the average value of the measured values of three samples was taken as the maximum tensile strength point after the moist heat treatment. The value, expressed in percentage, of the maximum tensile strength point of the test piece after the moist heat treatment with respect to the maximum tensile strength point of the test piece before the moist heat treatment (non-moist-heat-treated) was taken as the tensile strength retention rate.

(Maximum tensile strength point after moist heat treatment/maximum tensile strength point before moist heat treatment (non-moist-heat-treated)) $\times$ 100 = tensile strength retention rate (%)

A material having a larger value of tensile strength retention rate was judged to be more excellent in hydrolysis resistance.

(4) Electromagnetic wave absorbing properties

A test piece for evaluation of electromagnetic wave absorbing properties measuring 80 mm in width $\times$ 80 mm in length $\times$ 3 mm in thickness was formed under the same molding conditions as for the tensile properties in Section (2) using an SE50-DUZ injection molding machine manufactured by Sumitomo Heavy Industries, Ltd.

A network analyzer ME7838A manufactured by Anritsu Corporation was used to perform measurement. By the free space method, values of the reflection loss S11 and the transmission loss S21 at 79 GHz were calculated from the S-

parameter measurement results for the incident wave to and the transmitted wave through the test piece for evaluation of electromagnetic wave absorbing properties. The smaller the values of the reflection loss S11 and the transmission loss S21 at 79 GHz, that is, the larger the value of the attenuation rate, the more excellent the electromagnetic wave absorbing properties were judged to be.

(5) Volume resistivity

A test piece measuring 80 mm in width × 80 mm in length × 3 mm in thickness was prepared under the same molding conditions as for the tensile properties in Section (2) using an SE50-DUZ injection molding machine manufactured by Sumitomo Heavy Industries, Ltd. In accordance with IEC62631-3-1, the volume resistivity was measured by a double ring method using a high residence meter 4339B manufactured by Agilent Technologies, Inc. under the conditions of DC 100 V × 60 seconds.

(6) Laser marking property

A test piece for evaluation of laser marking measuring 80 mm in width × 80 mm in length × 3 mm in thickness was prepared under the same molding conditions as for the tensile properties in Section (2) using an SE50-DUZ injection molding machine manufactured by Sumitomo Heavy Industries, Ltd. On a surface of the prepared test piece, a marking portion measuring 20 mm in width × 20 mm in length was formed at a wavelength of 1064 nm using a FAYb laser marker LP-S200 manufactured by Panasonic Corporation. The marking portion was subjected to colorimetry with an SM color computer (SM-T) manufactured by Suga Test Instruments Co., Ltd., and the color difference (ΔE*ab) between an unmarked portion and the marking portion was measured. The larger ΔE*ab, the more excellent the laser marking property.

[Examples 1 to 12, Comparative Examples 1 to 8]

The thermoplastic polyester resin (A), the carbon nanotube (B), and other raw materials were mixed in the compositions shown in Tables 1 and 2 using a co-rotating twin-screw extruder with a vent (TEX30α manufactured by The Japan Steel Works, Ltd.) equipped with a screw having a screw diameter of 30 mm and L/D of 35, and added from a feeding portion of the twin-screw extruder. The contents of the fibrous reinforcing material (C), the vinyl copolymer (D), the component (E), and the compound (F) in Examples 6 to 10 of Table 1 are amounts based on 100 parts by weight of the thermoplastic polyester resin (A).

The fibrous reinforcing material (C) was added from a side feeder provided midway between the feeding portion and the vent portion of the twin-screw extruder.

When the thermoplastic polyester resin (A) was polybutylene terephthalate, melt mixing was carried out under the extrusion conditions of a kneading temperature of 250°C and a screw rotation speed of 150 rpm, and when the thermoplastic polyester resin (A) was polyethylene terephthalate, melt mixing was carried out under the extrusion conditions of a kneading temperature of 260°C and a screw rotation speed of 150 rpm. The obtained thermoplastic polyester resin was discharged into a strand shape, passed through a cooling bath, and pelletized by a strand cutter.

The obtained pellets were dried in a hot air dryer at a temperature of 110°C for 6 hours and then evaluated by the above-described method. The results are shown in Tables 1 and 2.

[Table 1]

| | | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|---|
| Thermoplastic polyester resin (A) | (A-1) Polybutylene terephthalate | parts by weight | 100 | 100 | 100 | 100 | 100 | 86.5 | 79.0 | 79.0 | 56.5 | 56.5 | 100 | |
| | (A-2) Polyethylene terephthalate | parts by weight | - | - | - | - | - | - | - | - | - | - | - | 100 |
| Carbon nanotube (B) | (B-1) Carbon nanotube A | parts by weight | 0.5 | 0.8 | 1.5 | 1.5 | 4.0 | - | - | - | - | - | - | 1.5 |
| | (B-2) Carbon nanotube B | parts by weight | - | - | - | - | - | - | - | - | - | - | 1.5 | |
| | (B'-3) Carbon nanotube C | parts by weight | - | - | - | - | - | - | - | - | - | - | - | - |
| | (B'-4) Carbon nanotube D | parts by weight | - | - | - | - | - | - | - | - | - | - | - | - |
| | (B-5) Carbon nanotube masterbatch | parts by weight | - | - | - | - | - | 15.0 | 15.0 | 15.0 | 15.0 | 15.0 | - | - |
| | Content of carbon nanotube (B) with respect to 100 parts by weight of thermoplastic polyester resin (A) | parts by weight | 0.5 | 0.8 | 1.5 | 1.5 | 4.0 | 1.5 | 1.6 | 1.6 | 2.1 | 2.1 | 1.5 | 1.5 |
| Fibrous reinforcing material (C) | (C-1) ECS 03 T-187 | parts by weight | 44.9 | 44.9 | 44.9 | 44.9 | 44.9 | 44.9 | 44.9 | 44.9 | 44.9 | 44.9 | 44.9 | 44.9 |
| Vinyl copolymer (D) | (D-1) Acrylonitrile/styrene/glycidyl methacrylate copolymer | parts by weight | - | - | - | - | - | - | - | - | 30.0 | 30.0 | - | - |

(continued)

| | | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|---|
| Ethylene/alkyl acrylate copolymer (E) | (E-1) "ELVALOY AC" 22534 | parts by weight | - | - | - | - | - | - | 7.5 | 7.5 | - | - | - | - |
| Compound (F) | (F-1) Epoxy resin HP7200H | parts by weight | - | - | - | 1.2 | - | - | - | 1.2 | - | 1.2 | - | - |
| Thermogravimetric analysis | Combustion peak temperature of carbon nanotube | °C | 688 | 688 | 688 | 688 | 688 | 688 | 688 | 688 | 688 | 688 | 675 | 688 |
| Volume resistivity | 3 mm square plate | Ω·m | $9.2\times10^{11}$ | $4.3\times10^{11}$ | $3.9\times10^{7}$ | $2.1\times10^{7}$ | $1.7\times10^{4}$ | $9.8\times10^{6}$ | $7.2\times10^{7}$ | $1.1\times10^{8}$ | $5.6\times10^{7}$ | $6.9\times10^{7}$ | $2.5\times10^{8}$ | $2.8\times10^{7}$ |
| Electromagnetic wave absorbing properties | Reflection loss S11 at 79 GHz | dB | -6.8 | -6.4 | -4.9 | -4.8 | -3.3 | -5.1 | -4.9 | -4.9 | -4.9 | -4.9 | -4.8 | -4.3 |
| | Transmission loss S21 at 79 GHz | dB | -24.3 | -27.3 | -44.2 | -46.1 | -51.4 | -47.4 | -47.6 | -48.7 | -48.2 | -49.3 | -39.3 | -45.2 |
| Tensile properties | Tensile strength | MPa | 141 | 143 | 143 | 145 | 147 | 146 | 147 | 148 | 146 | 147 | 142 | 161 |
| Hydrolysis resistance | Tensile strength retention rate after 50h of PCT treatment | % | 40 | 38 | 36 | 76 | 35 | 42 | 44 | 83 | 41 | 79 | 35 | 26 |
| Laser marking property | ΔE*ab | - | 9.1 | 7.3 | 5.2 | 5.5 | 4.3 | 5.9 | 6.1 | 6.6 | 6.4 | 6.8 | 4.1 | 5.3 |

[Table 2]

| | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|
| Thermoplastic polyester resin (A) | (A-1) Polybutylene terephthalate | parts by weight | 100 | 100 | 100 | 100 | 100 | 100 | - | - |
| | (A-2) Polyethylene terephthalate | parts by weight | - | - | - | - | - | - | 100 | 100 |
| Carbon nanotube (B) | (B-1) Carbon nano-tube A | parts by weight | - | 7.0 | - | - | - | - | - | 7.0 |
| | (B-2) Carbon nano-tube B | parts by weight | - | - | - | - | - | - | - | - |
| | (B'-3) Carbon nano-tube C | parts by weight | - | - | 0.8 | 1.5 | - | - | - | - |
| | (B'-4) Carbon nano-tube D | parts by weight | - | - | - | - | 0.8 | 1.5 | - | - |
| | (B-5) Carbon nano-tube masterbatch | parts by weight | - | - | - | - | - | - | - | - |
| Fibrous reinforcing material (C) | (C-1) ECS 03 T-187 | parts by weight | 44.9 | 44.9 | 44.9 | 44.9 | 44.9 | 44.9 | 44.9 | 44.9 |
| Vinyl copolymer (D) | (D-1) Acrylonitrile/s-tyrene/ glycidyl methacrylate copoly-mer | parts by weight | - | - | - | - | - | - | - | - |
| Ethylene/alkyl acry-late copolymer (E) | (E-1) "ELVALOY AC" 22534 | parts by weight | - | - | - | - | - | - | - | - |

(continued)

| | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|
| Compound (F) | (F-1) Epoxy resin HP7200H | parts by weight | - | - | - | - | - | - | - | - |
| Thermogravimetric analysis | Combustion peak temperature of carbon nanotube | °C | | 688 | 647 | 647 | 645 | 645 | | 688 |
| Volume resistivity | 3 mm square plate | Ω·m | $2.1\times10^{13}$ | $3.4\times10^{3}$ | $8.5\times10^{9}$ | $4.8\times10^{6}$ | $7.4\times10^{8}$ | $3.9\times10^{5}$ | $4.2\times10^{13}$ | $2.1\times10^{3}$ |
| Electromagnetic wave absorbing properties | Reflection loss S11 at 79 GHz | dB | -6.3 | -3.1 | -5.1 | -4.3 | -6.6 | -5.6 | -5.8 | -3.9 |
| | Transmission loss S21 at 79 GHz | dB | -1.3 | -59.4 | -16.5 | -22.8 | -17.6 | -23.6 | -1.8 | -58.2 |
| Tensile properties | Tensile strength | MPa | 140 | 150 | 142 | 142 | 140 | 139 | 160 | 163 |
| Hydrolysis resistance | Tensile strength retention rate after 50h of PCT treatment | % | 39 | 36 | 37 | 35 | 37 | 35 | 25 | 24 |
| Laser marking property | ΔE*ab | - | 24.1 | 1.8 | 3.2 | 2.6 | 2.5 | 1.8 | 28.3 | 1.5 |

Examples 1 to 12, as compared with Comparative Examples 1 to 8, enabled production of polyester resin compositions having excellent electromagnetic wave absorbing properties, mechanical strength, and laser marking property by containing the thermoplastic polyester resin (A) and a specific amount of the carbon nanotube (B) whose combustion peak temperature was within a specific range.

More specifically, Examples 1 to 3, as compared with Example 5, enabled production of polyester resin compositions having an excellent laser marking property because the volume resistivities of the resin compositions were within a more preferred range.

Example 4, as compared with Example 3, enabled production of a polyester resin composition having excellent electromagnetic wave absorbing properties, mechanical strength, laser marking property, and in addition, hydrolysis resistance by containing the compound (F).

Example 6, as compared with Example 3, showed improved dispersibility of the carbon nanotube (B) since a masterbatch of the carbon nanotube (B) was used. As a result, a polyester resin composition having more excellent electromagnetic wave absorbing properties, mechanical strength, and laser marking property could be obtained.

Example 7, as compared with Example 6, enabled production of a polyester resin composition having excellent electromagnetic wave absorbing properties, mechanical strength, laser marking property, and in addition, hydrolysis resistance by containing the component (E).

Examples 9 and 10, as compared with Example 6, enabled production of polyester resin compositions having a more excellent laser marking property by containing the component (D).

## Claims

1. A thermoplastic polyester resin composition comprising: 100 parts by weight of a thermoplastic polyester resin (A); and 0.1 to 5 parts by weight of a carbon nanotube (B) having a high-temperature-side combustion peak of 650°C to 900°C in thermogravimetric analysis upon heating in air at 10°C/min.

2. The thermoplastic polyester resin composition according to claim 1, wherein, when a 3 mm-thick square plate formed by molding the thermoplastic polyester resin composition is subjected to measurement by a free space method in a band of 60 to 90 GHz, the composition shows a reflection loss S11 of -3 dB or less and a transmission loss S21 of -20 dB or less.

3. The thermoplastic polyester resin composition according to claim 1 or 2, having a volume resistivity of $1.0 \times 10^5$ to $1.0 \times 10^{15}$ $\Omega \cdot m$.

4. The thermoplastic polyester resin composition according to claim 1 or 2, further comprising 1 to 100 parts by weight of a vinyl copolymer (D) with respect to 100 parts by weight of the thermoplastic polyester resin (A).

5. The thermoplastic polyester resin composition according to claim 1 or 2, further comprising 1 to 20 parts by weight of an ethylene/alkyl acrylate copolymer (E) with respect to 100 parts by weight of the thermoplastic polyester resin (A).

6. The thermoplastic polyester resin composition according to claim 1 or 2, further comprising 0.1 to 10 parts by weight of a compound (F) having in each molecule two or more functional groups capable of reacting with a carboxyl group with respect to 100 parts by weight of the thermoplastic polyester resin (A).

7. The thermoplastic polyester resin composition according to claim 6, wherein the compound (F) having in each molecule two or more functional groups capable of reacting with a carboxyl group is an epoxy compound.

8. The thermoplastic polyester resin composition according to claim 1 or 2, having electromagnetic wave absorbing properties.

9. A molded article obtained by molding the thermoplastic polyester resin composition according to claim 1 or 2.

**INTERNATIONAL SEARCH REPORT**

International application No. **PCT/JP2024/037353**

**A. CLASSIFICATION OF SUBJECT MATTER**

***C08L 67/00***(2006.01)i; ***C08K 3/04***(2006.01)i; ***C08L 33/08***(2006.01)i; ***C08L 63/00***(2006.01)i; ***C08L 63/08***(2006.01)i; ***H05K 9/00***(2006.01)i
FI: C08L67/00; C08K3/04; C08L63/08; C08L33/08; C08L63/00; H05K9/00 W

According to International Patent Classification (IPC) or to both national classification and IPC

**B. FIELDS SEARCHED**

Minimum documentation searched (classification system followed by classification symbols)

C08L67/00; C08K3/04; C08L33/08; C08L63/00; C08L63/08; H05K9/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2023/120455 A1 (TORAY INDUSTRIES, INC.) 29 June 2023 (2023-06-29) claims, paragraphs [0078]-[0091] | 1-9 |
| A | JP 2010-163568 A (TORAY INDUSTRIES, INC.) 29 July 2010 (2010-07-29) entire text | 1-9 |
| A | JP 2013-546179 A (C.R.F. SOCIETA CONSORTILE PER AZIONI) 26 December 2013 (2013-12-26) entire text | 1-9 |
| A | JP 2011-148877 A (ISHIDA CO., LTD.) 04 August 2011 (2011-08-04) entire text | 1-9 |
| A | JP 2006-241248 A (BUSSAN NANOTECH RESEARCH INSTITUTE INC.) 14 September 2006 (2006-09-14) entire text | 1-9 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 December 2024** | **17 December 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/037353**

| Patent document cited in search report | Publication date (day/month/year) | Patent family member(s) | Publication date (day/month/year) |
|---|---|---|---|
| WO 2023/120455 A1 | 29 June 2023 | CN 118234803 A | |
| JP 2010-163568 A | 29 July 2010 | (Family: none) | |
| JP 2013-546179 A | 26 December 2013 | US 2013/0255997 A1<br>entire text<br>EP 2448383 A1<br>CN 103262667 A | |
| JP 2011-148877 A | 04 August 2011 | (Family: none) | |
| JP 2006-241248 A | 14 September 2006 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2021256488 A
- JP 2023028689 A